# EUROPEAN PATENT APPLICATION

(11) **EP 4 395 480 A1**
(43) Date of publication of application: **03.07.2024**
(21) Application number: 23215572.1
(22) Date of filing: 11.12.2023
(51) Int. Cl.: H05K 5/02, H05K 7/20, H05K 7/14

(54) **ELECTRONIC DEVICE AND POWER SYSTEM**

(30) Priority: 30.12.2022 US 202263436203 P; 06.07.2023 CN 202310825703
(71) Applicant: Delta Electronics, Inc., Taoyuan City 33370 (TW)
(72) Inventor: Shen, Yu-Chieh, 32063 Taoyuan City (TW); Su, Chen-Chiang, 32063 Taoyuan City (TW); Lo, Yung-Chun, 32063 Taoyuan City (TW); Chen, Yen-Ting, 32063 Taoyuan City (TW); Lin, Ching-Jung, 32063 Taoyuan City (TW)
(74) Representative: Uexküll & Stolberg

(57) **Abstract**

An electronic device (1, 1a) and a power system (8) are provided. The electronic device (1, 1a) includes a shelf casing (2) and a filling component module (6). The shelf casing (2) includes a plurality of side walls (21, 22, 23, 24) disposed around in sequence. The filling component module (6) is disposed on the exterior of the shelf casing (2) and adjacent to at least one of the plurality of side walls (21, 22, 23, 24)

## Description

### FIELD OF THE INVENTION

The present disclosure relates to an electronic device and power system, and more particularly to an electronic device and power system including a filling component.

### BACKGROUND OF THE INVENTION

Generally, the electronic device is disposed within the server rack for providing the power to the facilities installed in the server rack. When the conventional electronic device is disposed within the server rack, the back side of the electronic device is adjacent to the back side of the server rack, and the front side of the electronic device is away from the back side of the server rack so as to expose the front side of the electronic device. The server rack includes a cooling slot. The plurality of electronic devices are disposed within the cooling slot of the server rack so as to dissipate the heat through the cooling liquid of the cooling slot. However, there is a huge gap between the electronic device and the cooling slot. The cooling slot of the server rack requires a large amount of the cooling liquid to fill the gap. Consequently, the cost of the server rack is increased.

Therefore, there is a need of providing an electronic device and power system to obviate the drawbacks encountered from the prior arts.

### SUMMARY OF THE INVENTION

The present disclosure provides an electronic device and power system. The electronic device includes a filling component module disposed on the exterior of the shelf casing and adjacent to at least one side wall of the plurality of side walls. When the electronic device is disposed within the cooling slot, the filling component module filles the gap between the electronic device and the cooling slot. Consequently, the gap between the electronic device and the cooling slot is reduced so as to reduce the volume and the cost of the cooling liquid.

In accordance with an aspect of the present disclosure, there is provided an electronic device. The electronic device includes a shelf casing and a filling component module. The shelf casing includes a plurality of side walls disposed around in sequence. The filling component module is disposed on the exterior of the shelf casing and adjacent to at least one of the plurality of side walls.

In accordance with another aspect of the present disclosure, there is provided a power system. The power system includes a cooling slot and a plurality of electronic devices. The cooling slot includes a cooling liquid. The plurality of electronic devices are immersed in the cooling liquid and arranged in sequence. Each of the plurality of electronic devices includes a shelf casing and a filling component module. The shelf casing includes a plurality of side walls disposed around in sequence. The filling component module is disposed on the exterior of the shelf casing and adjacent to at least one of the plurality of side walls for limiting a flowing direction of the cooling liquid.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a schematic view illustrating an electronic device according to a first embodiment of the present disclosure;
FIG. 2 is a schematic exploded view illustrating the electronic device as shown in FIG. 1;
FIG. 3 is a schematic view illustrating the electronic device as shown in FIG. 1 and taken along another viewpoint;
FIG. 4 is a schematic exploded view illustrating the electronic device as shown in FIG. 3;
FIG. 5 is a schematic exploded view illustrating a side frame module of the electronic device as shown in FIG. 1;
FIG. 6 is a front elevational view illustrating the electronic device as shown in FIG. 1;
FIG. 7 is a rear elevational view illustrating the electronic device as shown in FIG. 1;
FIG. 8 is a schematic view illustrating a third filling component of the side frame module of the electronic device as shown in FIG. 1;
FIG. 9 is a front elevational view illustrating an electronic device according to a second embodiment of the present disclosure;
FIG. 10 is a schematic view illustrating a power system of the present disclosure; and
FIG. 11 is a schematic view illustrating the power system as shown in FIG. 10 and taken along another viewpoint.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limit value to the precise form disclosed.

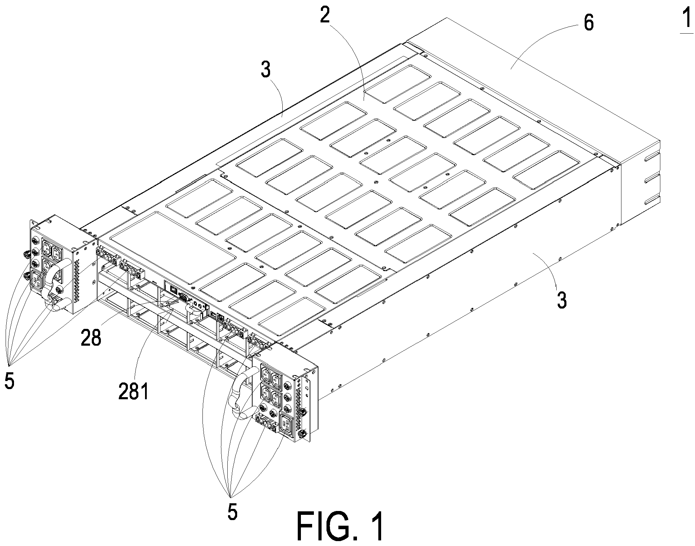

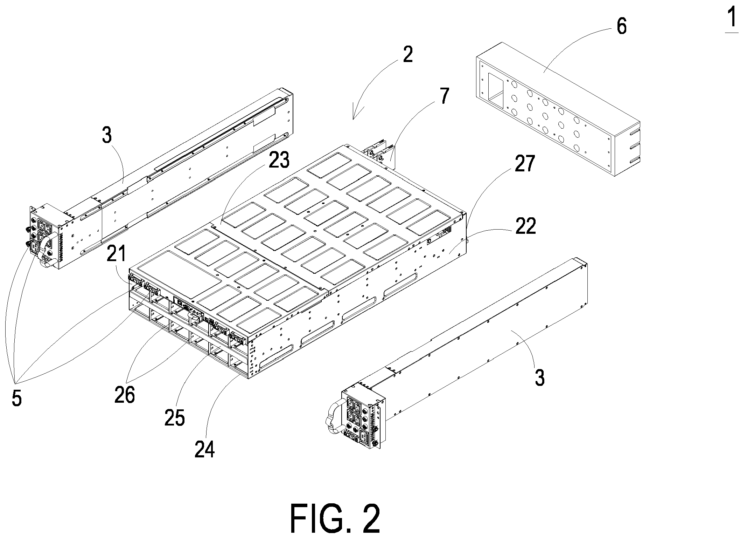

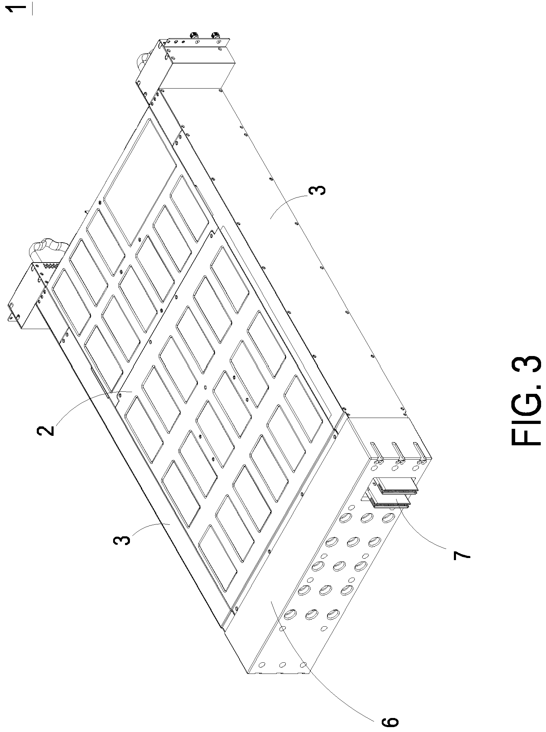

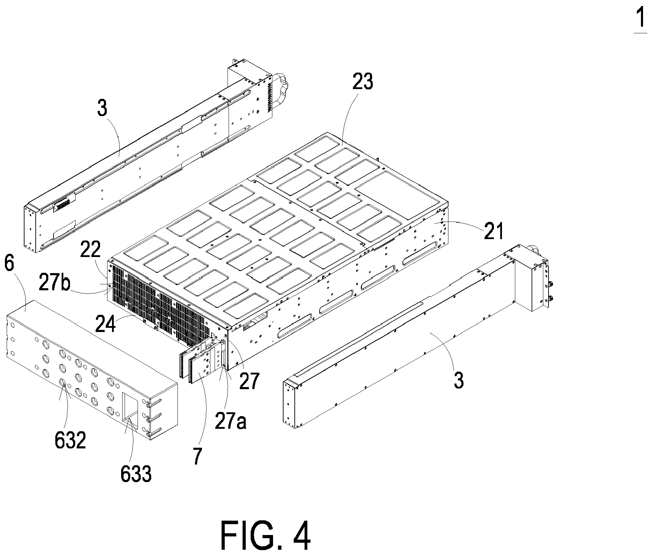

FIG. 1 is a schematic view illustrating an electronic device according to a first embodiment of the present disclosure. FIG. 2 is a schematic exploded view illustrating the electronic device as shown in FIG. 1. FIG. 3 is a schematic view illustrating the electronic device as shown in FIG. 1 and taken along another viewpoint. FIG. 4 is a schematic exploded view illustrating the electronic device as shown in FIG. 3. As shown in FIGS. 1 to 4, the electronic device 1 of the present disclosure is an industrial electronic device. For example, the industrial electronic device is a CRPS/MCRPS power device, an industrial power device, a server power device, a server or a networking device. The electronic device 1 is disposed within a cooling slot of a server rack (not shown) and accommodates a plurality of power modules (not shown) therein. The electronic device 1 receives an AC input power from a plurality of AC power sources and converts the AC input power into a DC output power through the plurality of power modules. A busbar module disposed in the back side of the electronic device 1 conveys the DC output power to the rack busbar of the server rack. Consequently, the electronic device 1 provides continuously DC output power to the other electronic facilities installed in the server rack. As shown in FIG. 2, the electronic device 1 includes a shelf casing 2, two side frame modules 3, an AC I/O power connection module 5, a filling component module 6 and a busbar module 7.

The shelf casing 2 includes a plurality of side walls. The filling component module 6 is disposed on at least one of the plurality of side walls. The detailed features of the side walls of the shelf casing 2 and the filling component module 6 are further described below.

In this embodiment, as shown in FIGS. 2 and 4, the shelf casing 2 includes a first side wall 21, a second side wall 22, a third side wall 23, a fourth side wall 24, a partition plate 25, a plurality of vertical plates 26 and a rear wall 27. The first side wall 21, the third side wall 23, the second side wall 22 and the fourth side wall 24 are disposed around in sequence. The first side wall 21 and the second side wall 22 are opposite to each other and disposed on two sides of the shelf casing 2. The third side wall 23 and the fourth side wall 24 are opposite to each other and disposed on two sides of the shelf casing 2. The third side wall 23 and the fourth side wall 24 are disposed between the first side wall 21 and the second side wall 22. The partition plate 25 is connected between the first side wall 21 and the second side wall 22 and perpendicular to the first side wall 21 and the second side wall 22. The partition plate 25 is parallel to the third side wall 23 and the fourth side wall 24. The rear wall 27 is connected with the first side wall 21, the second side wall 22, the third side wall 23 and the fourth side wall 24 and disposed on the back side of the shelf casing 2. As shown in FIG. 4, the rear wall 27 includes a second installation hole 27a and a second liquid channel 27b. The second installation hole 27a is adjacent to the first side wall 21, and the second liquid channel 27b is adjacent to the second side wall 22. In this embodiment, the number of the vertical plate 26 is ten. Five of the ten vertical plates 26 are arranged in sequence and connected between the third side wall 23 and the partition plate 25. Each of the five vertical plates 26 is parallel to the first side wall 21 and the second side wall 22. The partition plate 25, the third side wall 23, portion of the first side wall 21, portion of the second side wall 22 and the five vertical plates 26 forms six main accommodation spaces 28. Each of the six main accommodation spaces 28 includes a main opening 281 disposed on the front side of the shelf casing 2, as shown in FIG. 1. The other five of the ten vertical plates 26 are arranged in sequence and connected between the partition plate 25 and the fourth side wall 24. Each of the other five vertical plates 26 is parallel to the first side wall 21 and the second side wall 22. The partition plate 25, the fourth side wall 24, the other portion of the first side wall 21, the other portion of the second side wall 22 and the other five vertical plates 26 forms other six main accommodation spaces 28. Each of the six main accommodation spaces 28 includes a main opening 281 located on the front side of the shelf casing 2, as shown in FIG. 1. Each power module can be disposed within the corresponding main accommodation space 28 through the corresponding main opening 281 disposed on the front side of the shelf casing 2. For example, the shelf casing 2 of the electronic device 1 of this embodiment can receive twelve power modules.

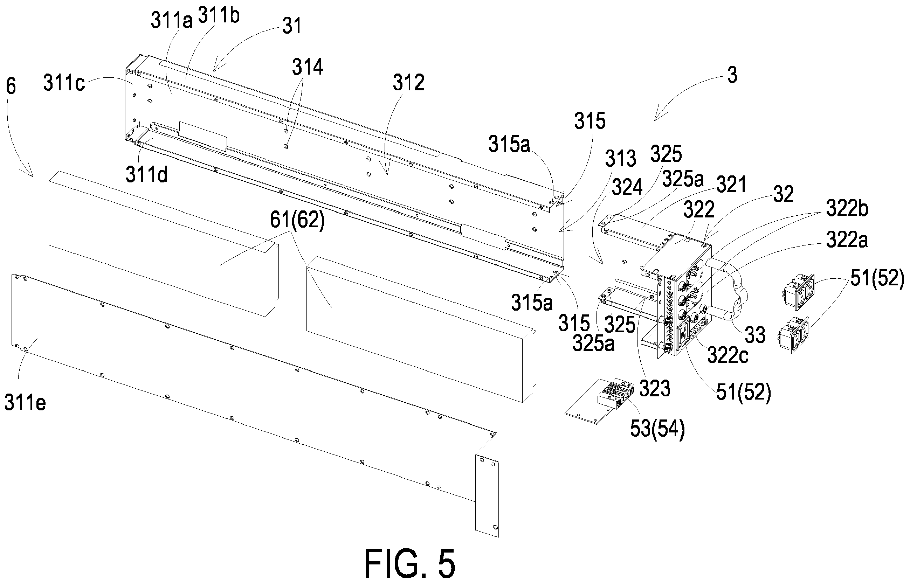

As shown in FIGS. 2 and 4, the two side frame modules 3 are disposed on two opposite sides of the shelf casing 2, respectively. One of the two side frame modules 3 is disposed and attached on the exterior of the first side wall 21 of the shelf casing 2. The other one of the two side frame modules 3 is disposed and attached on the exterior of the second side wall 22 of the shelf casing 2. For describing easily, the side frame module 3 disposed on the first side wall 21 is referred to as first side frame module 3, and the side frame module 3 disposed on the second side wall 22 is referred to as second side frame module 3. FIG. 5 is a schematic exploded view illustrating a side frame module of the electronic device as shown in FIG. 1. For simplifying the figure, FIG. 5 only shows one of the two side frame modules 3. It is obvious that the two side frame modules 3 are symmetrically disposed on two sides of the shelf casing 2, respectively. The following description is explained using the first side frame module 3 as an example.

As shown in FIGS. 2, 4 and 5, the first side frame module 3 includes a first frame 31 and a second frame 32. The first frame 31 includes a plurality of side surfaces, a first accommodation space 312 and a first opening 313. The plurality of side surfaces includes a first side surface 311a, a second side surface 311b, a third side surface 311c, a fourth side surface 311d and a fifth side surface 311e. The first side surface 311a is attached on the exterior of the first side wall 21 of the shelf casing 2. The second side surface 311b, the third side surface 311c and the fourth side surface 311d are disposed around and connected with the first side surface 311a. The first side surface 311a, the second side surface 311b, the third side surface 311c and the fourth side surface 311d define the first accommodation space 312 having the first opening 313. The fifth side surface 311e and the first side surface 311a are opposite to each other. The second side surface 311b, the third side surface 311c and the fourth side surface 311d are disposed between the fifth side surface 311e and the first side surface 311a. The fifth side surface 311e covers the first accommodation space 312. In this embodiment, the first side surface 311a of the first side frame module 3 adjacent to the first side wall 21 includes a plurality of penetrating holes 314. The penetrating hole 314 can be penetrated by a screw to fix the first side frame module 3 on the first side wall 21 of the shelf casing 2. In this embodiment, the first frame 31 of the first side frame module 3 includes two slide structures 315 disposed on the second side surface 311b and the fourth side surface 311d, respectively.

The second frame 32 is a L-shape frame and includes a long sub frame 321, a short sub frame 322, a second accommodation space 323 and a second opening 324. The long sub frame 321 and the short sub frame 322 are connected with each other and perpendicular to each other to form the L-shape frame. The long sub frame 321 and the short sub frame 322 define the second accommodation space 323 having the second opening 324. The long sub frame 321 includes two protrusions 325 disposed on the two opposite frame portions of the long sub frame 321, respectively. Each protrusion 325 is engaged with the corresponding slide structure 315 so as to connect the second frame 32 and the first frame 31 with each other. The first accommodation space 312 and the second accommodation space 323 are in communication with each other through the first opening 313 and the second opening 324. In an embodiment, the slide structure 315 includes a connection hole 315a, and the protrusion 325 includes a connection hole 325a. The connection hole 315a of the slide structure 315 is corresponding to the connection hole 325a of the protrusion 325. The connection hole 315a of the slide structure 315 and the connection hole 325a of the protrusion 325 are penetrated by a screw so as to fix the first frame 31 and the second frame 32 with each other. In this embodiment, the short sub frame 322 of the second frame 32 of the first side frame module 3 includes a front side plate 322a disposed on the front side of the shelf casing 2 and includes an input connection hole 322b and an output connection hole 322c. The first side frame module 3 further includes an ear-shape hook 33 disposed on the front side plate 322a of the short sub frame 322 of the second frame 32. When the electronic devices 1 needs to be maintained, the user can exert force on the ear-shape hook 33 so as to take the electronic devices 1 out from the server rack.

The structure of the second side frame module 3 of this embodiment is similar to the structure of the first side frame module 3. The first side surface 311a of the second side frame module 3 is attached on the exterior of the second side wall 22 of the shelf casing 2. The first side surface 311a of the first frame 31 of the second side frame module 3 adjacent to the second side wall 22 includes a plurality of penetrating holes 314. The penetrating hole 314 can be penetrated by a screw to fix the second side frame module 3 on the second side wall 22 of the shelf casing 2.

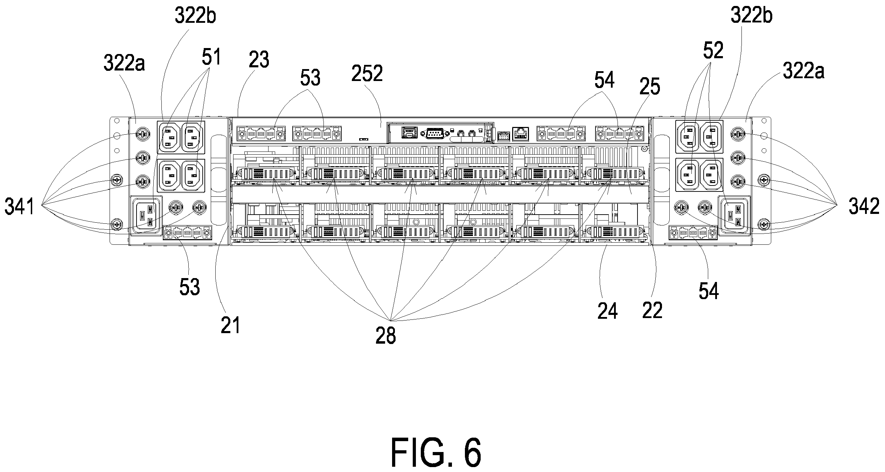

FIG. 6 is a front elevational view illustrating the electronic device as shown in FIG. 1. As shown in FIGS. 2, 5 and 6, the AC I/O power connection module 5 includes at least one first AC output power connector 51, at least one second AC output power connector 52, at least one first AC input power connector 53 and at least one second AC input power connector 54. In this embodiment, the AC I/O power connection module 5 includes three first AC output power connectors 51. The three first AC output power connectors 51 are not completely arranged in a straight line. Two of the three first AC output power connectors 51 are arranged in a straight line and adjacent to the main accommodation space 28. The two first AC output power connectors 51 shown in the top of FIG. 6 are arranged in a straight line and adjacent to the main accommodation space 28. The rest one of the three first AC output power connectors 51 is away from the main accommodation space 28. Compared with the two first AC output power connectors 51 shown in the top of FIG. 6, the rest one of the three first AC output power connectors 51 shown in the bottom of FIG. 6 is away from the main accommodation space 28. As shown in FIG. 6, the three first AC output power connectors 51 are penetrated through the corresponding input connection hole 322b of the front plate 322a of the short sub frame 322 of the second frame 32 of the first side frame module 3. At least portion of each first AC output power connector 51 is exposed from the front side of the shelf casing 2 so that the electronic device 1 outputs an AC input power through the first AC output power connector 51. In this embodiment, the AC I/O power connection module 5 includes a plurality of first fuses 341. For example, the AC I/O power connection module 5 includes seven first fuses 341, as shown in FIG. 6. Three of the seven first fuses 341 are arranged in a straight line. The two first AC output power connectors 51 shown in the top of FIG. 6 are disposed between the three first fuses 341 and the main accommodation space 28. The other two first fuses 341 are arranged in a straight line and disposed between the first AC output power connector 51 shown in the bottom of FIG. 6 and the main accommodation space 28. The rest two of the seven first fuses 341 are away from the main accommodation space 28.

As shown in FIG. 6, the AC I/O power connection module 5 includes three second AC output power connectors 52. The three second AC output power connectors 52 are not completely arranged in a straight line. Two of the three second AC output power connectors 52 are arranged in a straight line and adjacent to the main accommodation space 28. The two second AC output power connectors 52 shown in the top of FIG. 6 are arranged in a straight line and adjacent to the main accommodation space 28. The rest one of the three second AC output power connectors 52 is away from the main accommodation space 28. Compared with the two second AC output power connectors 52 shown in the top of FIG. 6, the rest one of the three second AC output power connectors 52 shown in the bottom of FIG. 6 is away from the main accommodation space 28. As shown in FIG. 6, the three second AC output power connectors 52 are penetrated through the corresponding input connection hole 322b of the front plate 322a of the short sub frame 322 of the second frame 32 of the second side frame module 3. At least portion of each second AC output power connector 52 is exposed from the front side of the shelf casing 2 so that the electronic device 1 outputs an AC input power through the second AC output power connector 52. In this embodiment, the AC I/O power connection module 5 includes a plurality of second fuses 342. For example, the AC I/O power connection module 5 includes seven second fuses 342, as shown in FIG. 6. Three of the seven second fuses 342 are arranged in a straight line. The two second AC output power connectors 52 shown in the top of FIG. 6 is disposed between the three second fuses 342 and the main accommodation space 28. The other two second fuses 342 are arranged in a straight line and disposed between the second AC output power connector 52 shown in the bottom of FIG. 6 and the main accommodation 28. The rest two of the seven second fuses 342 are away from the accommodation space 28.

As shown in FIG. 6, the AC I/O power connection module 5 includes three first AC input power connectors 53. Two of the three first AC input power connectors 53 are adjacent to the first side wall 21 and the third side wall 23 of the shelf casing 2. The rest one of the three first AC input power connectors 53 is penetrated through the corresponding output connection hole 322c of the front plate 322a of the short sub frame 322 of the second frame 32 of the first side frame module 3. At least portion of each first AC input power connector 53 is exposed from the front side of the shelf casing 2 so that the electronic device 1 receives an AC output power provided from the AC power source through the first AC input power connector 53. The AC I/O power connection module 5 includes three second AC input power connectors 54. Two of the three second AC input power connectors 54 are adjacent to the second side wall 22 and the third side wall 23 of the shelf casing 2. The rest one of the three second AC input power connectors 54 is penetrated through the corresponding output connection hole 322c of the front plate 322a of the short sub frame 322 of the second frame 32 of the second side frame module 3. At least portion of each second AC input power connector 54 is exposed from the front side of the shelf casing 2 so that the electronic device 1 receives an AC output power provided from the AC power source through the second AC input power connector 54.

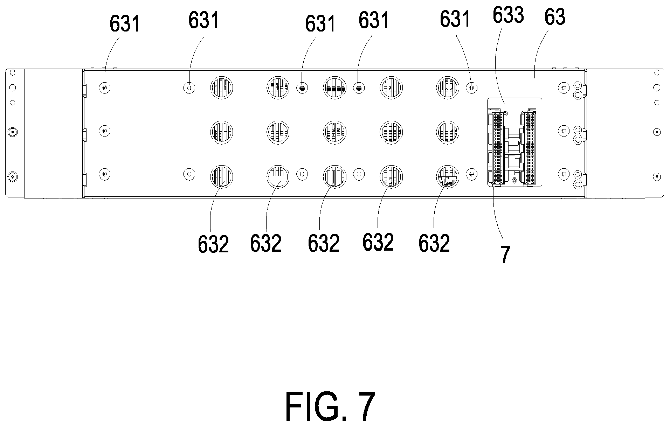

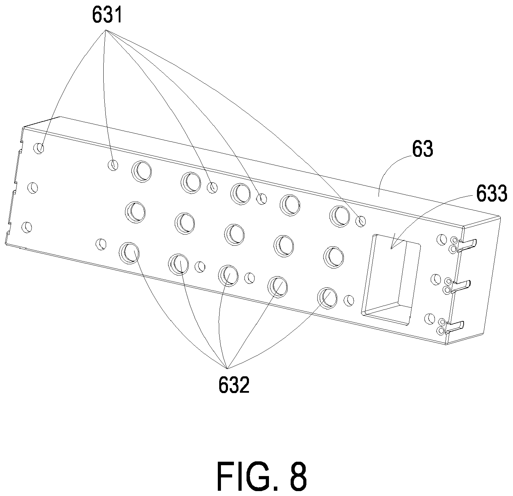

FIG. 7 is a rear elevational view illustrating the electronic device as shown in FIG. 1. FIG. 8 is a schematic view illustrating a third filling component of the side frame module of the electronic device as shown in FIG. 1. As shown in FIGS. 5 and 7, the filling component module 6 comprises a waterproof foam, a plastic injection molding or a metal structure and includes a first filling component 61, a second filling component 62 and a third filling component 63. As shown in FIG. 5, the first filling component 61 and the second filling component 62 are side filling components. The first filling component 61 is disposed within a space formed with the first accommodation space 312 of the first frame 31 and the second accommodation space 323 of the second frame 32 of the first side frame module 3 collaboratively. The first filling component 61 is disposed between the first side surface 311a and the fifth side surface 311e of the first frame 31 of the first side frame module 3 and adjacent to the first side wall 21 of the shelf casing 2. In some embodiments, the first frame 31 of the first side frame module 3 omits the fifth side surface so as to expose the first filling component 61 to the exterior of the first frame 31 of the first side frame module 3. The second filling component 62 is disposed within a space formed with the first accommodation space 312 of the first frame 31 and the second accommodation space 323 of the second frame 32 of the second side frame module 3 collaboratively. The second filling component 62 is disposed between the first side surface 311a and the fifth side surface 311e of the first frame 31 of the second side frame module 3 and adjacent to the second side wall 22 of the shelf casing 2. In some embodiments, the first frame 31 of the second side frame module 3 omits the fifth side surface so as to expose the second filling component 62 to the exterior of the first frame 31 of the second side frame module 3. As shown in FIGS. 2 and 4, the third filing component 63 is disposed on the back side of the electronic device 1 and adjacent to the rear wall 27 of the shelf casing 2. In some embodiments, the filling component module 6 can be disposed adjacent to the third side wall 23 and/or the fourth side wall 24.

As shown in FIGS. 7 and 8, the third filling component 63 further includes a plurality of foam fixing holes 631, a plurality of first liquid channels 632 and a first installation hole 633. The plurality of foam fixing holes 631, the plurality of first liquid channels 632 and the first installation hole 633 run through the shelf casing 2 perpendicular to the rear wall 27 of the shelf casing 2. The foam fixing hole 631 can be penetrated by a screw to fix the third filling component 63 on the rear wall 27 of the shelf casing 2. The plurality of first liquid channels 632 of the third filling component 63 and the second liquid channel 27b of the rear wall 27 are in communication with each other, so that the cooling liquid passes through the first liquid channel 632 and the second liquid channel 27b of the electronic device 1. The first installation hole 633 of the third filling component 63 and the second installation hole 27a of the rear wall 27 are in communication with each other. The electronic device 1 of the present disclosure is disposed within the server rack so as to dissipate the heat through the cooling liquid. The cost of the cooling liquid is high. Consequently, the volume of the cooling liquid of the server rack is reduced because of the installation of the first filling component 61, the second filling component 62 and the third filling component 63 so as to reduce the cost of the cooling liquid.

Please refers to FIGS. 3 and 4, at least portion of the busbar module 7 is disposed in the interior of the shelf casing 2. The other portion of the busbar module 7 is penetrated through the second installation hole 27a of the rear wall 27 and the first installation hole 633 of the third filling component 63 and disposed on the exterior of the shelf casing 2. The busbar module 7 conveys the DC output power to the rack busbar of the server rack.

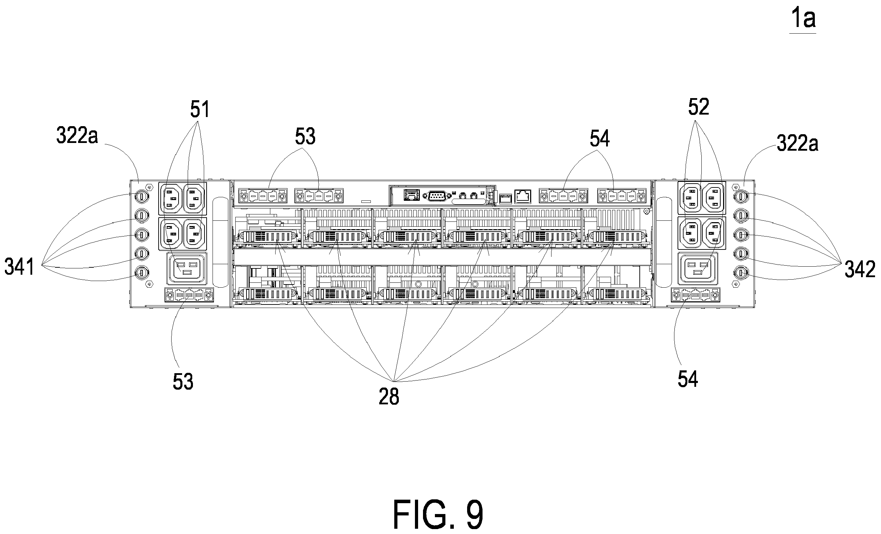

FIG. 9 is a front elevational view illustrating an electronic device according to a second embodiment of the present disclosure. Compared with the electronic device 1 of the first embodiment, the three first AC output power connectors 51 of the electronic device 1a of this embodiment are arranged in a straight line and adjacent to the main accommodation space 28, and the three second AC output power connectors 52 of the electronic device 1a of this embodiment are arranged in a straight line and adjacent to the main accommodation space 28. In this embodiment, the number of the first fuse 341 and the number of the second fuse 342 of the AC I/O power connection module 5 are five, respectively. As shown in FIG. 9, the five first fuses 341 are arranged in a straight line. The arrangement direction of the five first fuses 341 is parallel to the arrangement direction of the three first AC output power connectors 51. The three first AC output power connectors 51 is disposed between the five first fuses 341 and the main accommodation space 28. The five second fuses 342 are arranged in a straight line. The arrangement direction of the five second fuses 342 is parallel to the arrangement direction of the three second AC output power connectors 52. The three second AC output power connectors 52 are disposed between the five second fuses 342 and the main accommodation space 28.

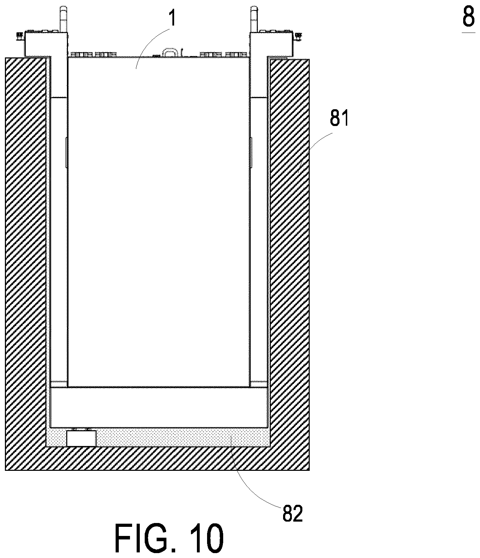

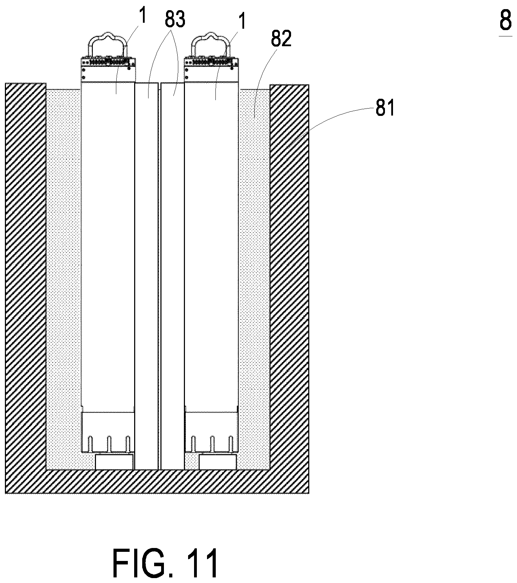

FIG. 10 is a schematic view illustrating a power system of the present disclosure. FIG. 11 is a schematic view illustrating the power system as shown in FIG. 10 and taken along another viewpoint. As shown in FIGS. 1 to 4, 10 and 11, the power system 8 of the present disclosure includes a cooling slot 81, a plurality of electronic devices 1 and a system filling component 83. The electronic device 1 of the first embodiment is shown in FIGS. 10 and 11. Certainly, the electronic device 1a of the second embodiment or other electronic device can be utilized by the power system 8. The cooling slot 81 is disposed within the server rack and includes a cooling liquid 82. The plurality of electronic devices 1 are immersed in the cooling liquid 82 of the cooling slot 81 and arranged in sequence. The system filling component 83 is disposed between the two adjacent electronic devices 1. The system filling component 83 can be disposed and fixed on any electronic device 1 or any wall of the cooling slot 81. Similar to the filling component of the above embodiment, the system filling component 83 of this embodiment includes a liquid channel similar to the liquid channel of the filling component of the above embodiment, and is not redundantly described hereinafter. The cooling liquid 82 of the cooling slot 81 passes through the liquid channel of the system filling component 83 so as to limit or guide the flowing direction or the flowing speed of the cooling liquid 82. In some embodiments, the system filling component 83 can be disposed between the electronic device 1 and the wall of the cooling slot 81.

From above descriptions, the electronic device of the present disclosure includes a filling component module disposed on the exterior of the shelf casing and adjacent to at least one side wall of the plurality of side walls. When the electronic device is disposed within the colling slot, the filling component module filles the gap between the cooling slot and the electronic device. Consequently, the gap between the cooling slot and the electronic device is reduced so as to reduce the volume and the cost of the cooling liquid.

## Claims

1. An electronic device (1, 1a), **characterized by** comprising:
a shelf casing (2) comprising a plurality of side walls (21, 22, 23, 24) disposed around in sequence; and
a filling component module (6) disposed on the exterior of the shelf casing (2) and adjacent to at least one of the plurality of side walls (21, 22, 23, 24).

2. The electronic device (1, 1a) according to claim 1, wherein the electronic device (1, 1a) is an industrial electronic device (1, 1a), wherein the industrial electronic device (1, 1a) is a CRPS/MCRPS power device, an industrial power device, a server power device, a server or a networking device.

3. The electronic device (1, 1a) according to claim 1, wherein the electronic device (1, 1a) comprises a first side frame module (3) and a second side frame module (3), the plurality of side walls (21, 22, 23, 24) of the shelf casing (2) comprises a first side wall (21) and a second side wall (22) opposite to each other, the first side frame module (3) is disposed on the exterior of the shelf casing (2) and attached on the first side wall (21) of the shelf casing (2), the first side frame module (3) comprises an accommodation space (312), the second side frame module (3) is disposed on the exterior of the shelf casing (2) and attached on the second side wall (22) of the shelf casing (2), and the second side frame module (3) comprises an accommodation space (312).

4. The electronic device (1, 1a) according to claim 3, wherein the first side frame module (3) comprises a frame (31), the frame (31) comprises a first side surface (311a), a second side surface (311b), a third side surface (311c) and a fourth side surface (311d), the first side surface (311a) is attached on the first side wall (21), wherein the second side surface (311b), the third side surface (311c) and the fourth side surface (311d) are disposed around and connected with the first side surface (311a), wherein the first side surface (311a), the second side surface (311b), the third side surface (311c) and the fourth side surface (311d) define the accommodation space (312) of the first side frame module (3), wherein the filling component module (6) comprises a first filling component (61), and the first filling component (61) is disposed within the accommodation space (312) of the first side frame module (3).

5. The electronic device (1, 1a) according to claim 4, wherein the frame comprises a fifth side surface (311e) opposite to the first side surface (311a), wherein the second side surface (311b), the third side surface (311c) and the fourth side surface (311d) are disposed between the first side surface (311a) and the fifth side surface (311e), wherein the fifth side surface (311e) covers the accommodation space (312) of the first side frame module (3), wherein the first filling component (61) is disposed between the first side surface (311a) and the fifth side surface (311e).

6. The electronic device (1, 1a) according to claim 3, wherein the second side frame module (3) comprises a frame (31), the frame (31) comprises a first side surface (311a), a second side surface (311b), a third side surface (311c) and a fourth side surface (311d), the first side surface (311a) is attached on the second side wall (22), wherein the second side surface (311b), the third side surface (311c) and the fourth side surface (311d) are disposed around and connected with the first side surface (311a), wherein the first side surface (311a), the second side surface (311b), the third side surface (311c) and the fourth side surface (311d) define the accommodation space (312) of the second side frame module (3), wherein the filling component module (6) comprises a second filling component (62), and the second filling component (62) is disposed within the accommodation space (312) of the second side frame module (3).

7. The electronic device (1, 1a) according to claim 6, wherein the frame (31) comprises a fifth side surface (311e) opposite to the first side surface (311a), wherein the second side surface (311b), the third side surface (311c) and the fourth side surface (311d) are disposed between the first side surface (311a) and the fifth side surface (311e), wherein the fifth side surface (311e) covers the accommodation space (312) of the second side frame module (3), wherein the second filling component (62) is disposed between the first side surface (311a) and the fifth side surface (311e).

8. The electronic device (1, 1a) according to claim 1, wherein the filling component module (6) comprises a third filling component (63), the shelf casing (2) comprises a rear wall (27) disposed in a back side thereof, the third filling component (63) is disposed on the rear wall (27) of the shelf casing (2), and the third filling component (63) comprises a first installation hole (633).

9. The electronic device (1, 1a) according to claim 8, wherein the rear wall (27) of the shelf casing (2) comprises a second installation hole (27a) corresponding to the first installation hole (633) of the third filling component (63), the electronic device (1, 1a) comprises a busbar module (7), at least portion of the busbar module (7) is disposed in the interior of the shelf casing (2), and the other portion of the busbar module (7) is penetrated through the second installation hole (27a) of the rear wall (27) and the first installation hole (633) of the third filling component (63) and disposed on the exterior of the shelf casing (2).

10. The electronic device (1, 1a) according to claim 1, wherein the third filling component (63) comprises a first liquid channel (632), the shelf casing (2) comprises a rear wall (27) disposed in a back side thereof, the rear wall (27) of the shelf casing (2) comprises a second liquid channel (27b), the second liquid channel (27b) of the rear wall (27) is in communication with the first liquid channel (632) of the third filling component (63), so that a liquid passes through the first liquid channel (632) and the second liquid channel (27b).

11. The electronic device (1, 1a) according to claim 1, wherein the filling component module (6) comprises a waterproof foam, a plastic injection molding or a metal structure.

12. A power system (8), **characterized by** comprising:
a cooling slot (81) comprising a cooling liquid (82); and
a plurality of electronic devices (1, 1a) immersed in the cooling liquid (82) and arranged in sequence, wherein each of the plurality of electronic devices (1, 1a) comprises:
a shelf casing (2) comprising a plurality of side walls (21, 22, 23, 24) disposed around in sequence; and
a filling component module (6) disposed on the exterior of the shelf casing (2) and adjacent to at least one of the plurality of side walls (21, 22, 23, 24) for limiting a flowing direction of the cooling liquid (82).

13. The power system (8) according to claim 12, wherein the power system (8) comprises at least one system filling component (83) disposed between any two adjacent electronic devices (1, 1a) of the plurality of electronic devices (1, 1a).

14. The power system (8) according to claim 12, wherein the power system (8) comprises at least one system filling component (83) disposed between any one of the plurality of electronic devices (1, 1a) and a side wall of the cooling slot (81).

15. The power system (8) according to claim 13, wherein the at least one system filling component (83) comprises a liquid channel for allowing the cooling liquid (82) to pass therethrough.
